# EUROPEAN PATENT APPLICATION

(11) **EP 2 924 790 A1**
(43) Date of publication of application: **30.09.2015**
(21) Application number: 15160148.1
(22) Date of filing: 20.03.2015
(51) Int. Cl.: H01M 8/04, H01M 8/10

(54) **Fuel cell system, drying state estimation method, and fuel cell system control method**

(30) Priority: 24.03.2014 JP 2014060238
(71) Applicant: Toyota Jidosha Kabushiki Kaisha, Toyota-shi, Aichi-ken 471-8571 (JP)
(72) Inventor: Matsusue, Masaaki, Aichi-ken, 471-8571 (JP)
(74) Representative: Smith, Samuel Leonard

(57) **Abstract**

A fuel cell system includes a sensor (76a, 76b) that measures temperature of a medium for cooling a fuel cell, an acquisition part (21) that acquires frequency of load variation of a fuel cell per unit time, and an estimation part (22) that is able to estimate a drying state of the fuel cell based on information including the temperature and the frequency of load variation.

## Description

### BACKGROUND OF THE INVENTION

### 1. Field of the Invention

The invention relates to a fuel cell system, a drying state estimation method, and a fuel cell system control method.

### 2. Description of Related Art

A fuel cell system, which diagnoses various states (an inner water content, a current density, and so on) of a fuel cell, is known (for example, Japanese Patent Application Publication No. 2013-118140 (JP 2013-118140 A)).

Techniques described in JP 2013-118140 A are for detecting a difference of current flowing in at least two locations in a cell of a fuel cell and determining a drying state of the fuel cell in accordance with detected values.

However, in the techniques of JP 2013-118140 A, since parts for measuring current values of at least two locations in a battery cell are required, there is a problem that costs for manufacturing a fuel cell are increased. In addition, for a conventional fuel cell system, simplification of a structure, resource saving, easy manufacturing, improved convenience have been desired.

### SUMMARY OF THE INVENTION

A first aspect of the invention relates to a fuel cell system, which includes a sensor that measures temperature of a medium for cooling a fuel cell, an acquisition part configured to acquire frequency of load variation of the fuel cell per unit time, and an estimation part configured to estimate whether or not the fuel cell is in a drying state based on information including the measured temperature and the acquired frequency of load variation. According to the fuel cell system, it is possible to estimate whether or not the fuel cell is in a drying state by using equipment that is usually provided in the fuel cell system.

Further, the fuel cell system may include an improvement part configured to improve a drying state in a case where it is estimated that the fuel cell is in a drying state. According to this fuel cell system, it is possible to improve a drying state of the fuel cell by using equipment that is usually provided in the fuel cell system.

The estimation part may not estimate whether or not the fuel cell is in a drying state in a case where the measured temperature is lower than a threshold value, and the estimation part may estimate whether or not the fuel cell is in a drying state in a case where the measured temperature is equal to or higher than the threshold value. According to the fuel cell system in this form, the estimation part does not make estimation when the temperature is lower that the threshold value. Therefore, according to the fuel cell system in this form, processing is simplified.

A second aspect of the invention relates to an estimation method which includes measuring temperature of a medium for cooling a fuel cell, acquiring frequency of load variation of the fuel cell per unit time, and estimating whether or not the fuel cell is in a drying state based on information including the measured temperature and the acquired frequency of load variation. According to this method, it is possible to estimate whether or not the fuel cell is in a drying state by using equipment that is usually provided in the fuel cell system.

A third aspect of the invention relates to a fuel cell system control method. The method includes carrying out the estimation method described above, and improving a drying state when it is estimated that the fuel cell is in a drying state.

It is possible to realize the invention in various types of forms. For example, it is possible to realize the invention in forms such as a manufacturing method for a fuel cell system, a computer program that realizes the manufacturing method, and a recording medium that records the computer program.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a schematic view showing a structure of a fuel cell system 100 as an embodiment of the invention;
FIG. 2 is a schematic view showing an electrical structure of the fuel cell system 100;
FIG. 3 is a view showing a relation between cell voltage and refrigerant temperature;
FIG. 4 is a view showing a relation between a position in a cell and current density;
FIG. 5 is an explanatory view showing a flow of control processing of the fuel cell system 100 according to the first embodiment;
FIG. 6 is a view showing a relation between frequency of load variation and refrigerant temperature;
FIG. 7A to FIG. 7C are views for explaining detection of a drying state and dryness suppression control; and
FIG. 8A and FIG. 8B are views for explaining detection of a drying state and dryness suppression control.

### DETAILED DESCRIPTION OF EMBODIMENTS

A. First embodiment:
A1. Structure of a fuel cell system 100:

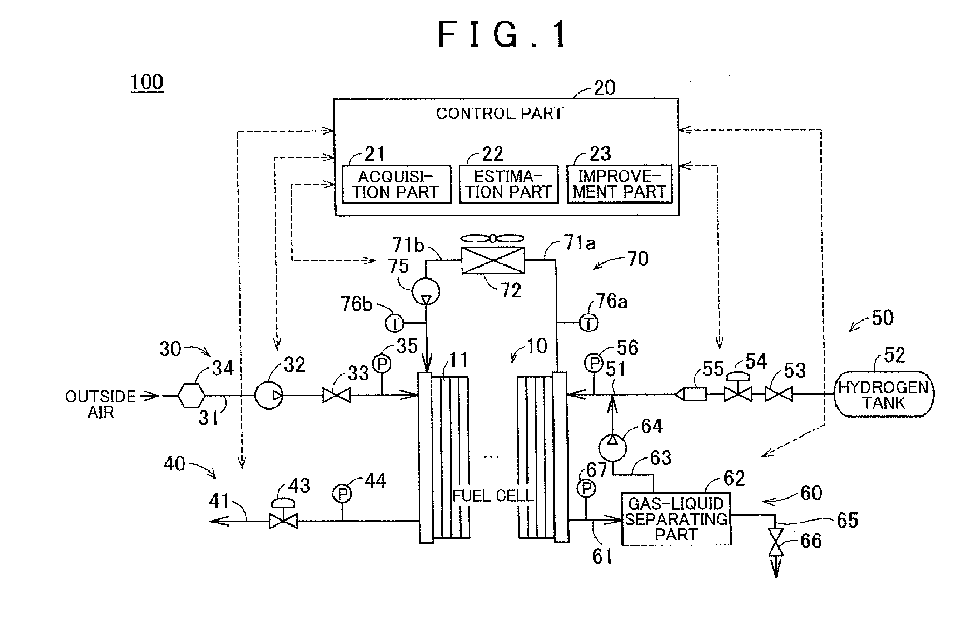

   FIG. 1 is a schematic view showing a structure of a fuel cell system 100 as an embodiment of the invention. In this embodiment, the fuel cell system 100 is mounted on a vehicle. The fuel cell system 100 outputs electric power that serves as a source of power for a vehicle, in response to a request from a driver of the vehicle.

The fuel cell system 100 is provided with a fuel cell 10, a control part 20, a cathode gas supply system 30, a cathode gas discharge system 40, an anode gas supply system 50, an anode gas discharge system 60, and a refrigerant circulation system 70.

The fuel cell 10 is a polymer electrolyte fuel cell that receives supply of hydrogen as anode gas and air as cathode gas, and generates power. Herein after, the anode gas and the cathode gas are also collectively referred to as "reactant gas". The fuel cell 10 has a stack structure in which a plurality of single cells 11 is stacked. In this embodiment, the fuel cell 10 is a so-called counter flow-type fuel cell where anode gas and cathode gas flow in opposite directions against each other. Although not shown, manifolds for the reactant gas and refrigerant are formed in the fuel cell 10 as through holes along a stacking direction.

The single cell 11 includes a membrane electrode assembly, and two separators (not shown) that are plate-shaped base materials which sandwich the membrane electrode assembly and form flow passages for the reactant gas and the refrigerant, and also work as current collector plates. The membrane electrode assembly has an electrolyte membrane, and electrodes arranged on both surfaces of the electrolyte membrane. The electrolyte membrane is a solid polymer membrane that shows good proton conductivity in a wet state. In this embodiment, the electrolyte membrane contains sulfonate group (-SO₃H) as an ion-exchange goup.

The electrode is formed as a membrane by applying so-called catalyst ink. Here, the "catalyst ink" means dispersion liquid, in which conductive particles and ionomer are dispersed. In the conductive particles, catalyst for promoting power generation reaction is supported, and the ionomer is the same kind of or similar to ionomer that structures the electrolyte membrane 1. In this embodiment, platinum (Pt) is employed as the catalyst, and carbon (C) particles are employed as the conductive particles.

The control part 20 is structured by a microcomputer that is provided with a central processing unit and a main storage device. The control part 20 controls the cathode gas supply system 30, the cathode gas discharge system 40, the anode gas supply system 50, the anode gas discharge system 60, and the refrigerant circulation system 70, which are explained below, and causes the fuel cell 10 to generate electric power in accordance with an output request to the system from outside.

The cathode gas supply system 30 is provided with a cathode gas piping 31, an air flow meter 32, an opening-closing valve 33, an air compressor 34, and a pressure measuring part 35. The cathode gas piping 31 is piping connected to a supply manifold on a cathode side of the fuel cell 10. The air compressor 34 is connected with the fuel cell 10 through the cathode gas piping 31. The air compressor 34 supplies air, which has been taken in from outside and compressed, to the fuel cell 10 as the cathode gas.

On an downstream side of the air compressor 34, the air flow meter 32 measures an amount of outside air taken in by the air compressor 34, and sends the measurement value to the control part 20. The control part 20 controls an amount of air supplied to the fuel cell 10 by driving the air compressor 34 based on the measurement value.

The opening-closing valve 33 is provided between the air compressor 34 and the fuel cell 10. The opening-closing valve 33 is usually in a closed state, and opens when air having predetermined pressure is supplied from the air compressor 34 to the cathode gas piping 31. The pressure measuring part 35 measures pressure of air in the vicinity of an inlet of a supply manifold on the cathode side of the fuel cell 10, and outputs the measurement result to the control part 20.

The cathode gas discharge system 40 is provided with a cathode exhaust gas piping 41, a pressure regulating valve 43, and a pressure measuring part 44. The cathode exhaust gas piping 41 is piping that is connected to a discharge manifold on the cathode side of the fuel cell 10. Cathode exhaust gas is discharged outside the fuel cell system 100 through the cathode exhaust gas piping 41.

Opening of the pressure regulating valve 43 is controlled by the control part 20 to adjust pressure of cathode exhaust gas in the cathode exhaust gas piping 41 (back pressure of the cathode side of the fuel cell 10). The pressure measuring part 44 is provided on an upstream side of the pressure regulating valve 43, measures pressure of cathode exhaust gas, and outputs the measurement result to the control part 20.

The anode gas supply system 50 is provided with an anode gas piping 51, a hydrogen tank 52, an opening-closing valve 53, a regulator 54, a hydrogen feeder 55, and a pressure measuring part 56. The hydrogen tank 52 is connected with a supply manifold on an anode side of the fuel cell 10 through the anode gas piping 51, and supplies hydrogen filled in the tank to the fuel cell 10.

The opening-closing valve 53, the regulator 54, the hydrogen feeder 55, and the pressure measuring part 56 are provided in the anode gas piping 51 in this order from an upstream side (the side of the hydrogen tank 52). The opening-closing valve 53 opens and closes in accordance with a command from the control part 20 and controls an inflow of hydrogen from the hydrogen tank 52 to the upstream side of the hydrogen feeder 55. The regulator 54 is a pressure reducing valve for adjusting pressure of hydrogen on the upstream side of the hydrogen feeder 55, and opening of the regulator 54 is controlled by the control part 20.

The hydrogen feeder 55 is able to be structured by, for example, an injector that is an electromagnetic drive opening-closing valve. The pressure measuring part 56 measures pressure of hydrogen on a downstream side of the hydrogen feeder 55, and sends the measurement value to the control part 20. The control part 20 controls a flow rate of hydrogen supplied to the fuel cell 10 by controlling the hydrogen feeder 55 based on the measurement value of the pressure measuring part 56.

The anode gas discharge system 60 is provided with an anode exhaust gas piping 61, a gas-liquid separating part 62, anode gas circulation piping 63, a hydrogen circulation pump 64, anode drain piping 65, a drain valve 66, and a pressure measuring part 67. The anode gas discharge system 60 circulates and discharges anode exhaust gas that contains unreacted gas (hydrogen, nitrogen, and so on) and discharged water, which are discharged from the anode of the fuel cell 10 without being used for power generation reaction.

The anode exhaust gas piping 61 is piping that connects the gas-liquid separating part 62 with an outlet of an anode side discharge manifold (not shown) of the fuel cell 10. The gas-liquid separating part 62 is connected with the anode gas circulation piping 63 and the anode drain piping 65. The gas-liquid separating part 62 separates a gas component and moisture contained in anode exhaust gas, guides the gas component to the anode gas circulation piping 63, and guides moisture to the anode drain piping 65.

The anode gas circulation piping 63 is connected with the anode gas piping 51 downstream of the hydrogen feeder 55. The anode gas circulation piping 63 is provided with the hydrogen circulation pump 64. Hydrogen contained in the gas component separated by the gas-liquid separating part 62 is sent out to the anode gas piping 51 by the hydrogen circulation pump 64.

The anode drain piping 65 is piping for discharging moisture, which has been separated by the gas-liquid separating part 62, to outside the fuel cell system 100. The anode drain piping 65 is provided with the drain valve 66. The control part 20 usually closes the drain valve 66, and opens the drain valve 66 at predetermined timing for draining that is set in advance, and timing for discharging inert gas contained in anode exhaust gas.

The pressure measuring part 67 of the anode gas discharge system 60 is provided in the anode exhaust gas piping 61. The pressure measuring part 67 measures pressure of anode exhaust gas in the vicinity of an outlet of a hydrogen manifold of the fuel cell 10 (back pressure of the anode side of the fuel cell 10), and sends the measurement value to the control part 20. The control part 20 controls supply of hydrogen to the fuel cell 10 based on the measurement value of the pressure measuring part 56 of the anode gas discharge system 60, and the measurement value of the aforementioned pressure measuring part 56 of the anode gas supply system 50.

The refrigerant circulation system 70 is provided with upstream side piping 71a, downstream side piping 71b, a radiator 72, a refrigerant circulation pump 75, an upstream side temperature sensor 76a, and a downstream side temperature sensor 76b. The upstream side piping 71 a and the downstream side piping 71b are piping for refrigerant, which circulates refrigerant for cooling the fuel cell 10. The upstream side piping 71 a connects an inlet of the radiator 72 with an outlet of a refrigerant discharge manifold (not shown) of the fuel cell 10. The downstream side piping 71b connects an outlet of the radiator 72 with an inlet of the refrigerant supply manifold (not shown) of the fuel cell 10.

The radiator 72 cools refrigerant by exchanging heat between the refrigerant flowing in the piping for refrigerant, and outside air. The refrigerant circulation pump 75 is provided in a middle of the downstream side piping 71b, and sends the refrigerant cooled by the radiator 72 out to the fuel cell 10. The upstream side temperature sensor 76a is provided in the upstream side piping 71a, and the downstream side temperature sensor 76b is provided in the downstream side piping 71b. Each of the upstream side temperature sensor 76a and the downstream side temperature sensor 76b sends measured refrigerant temperature to the control part 20.

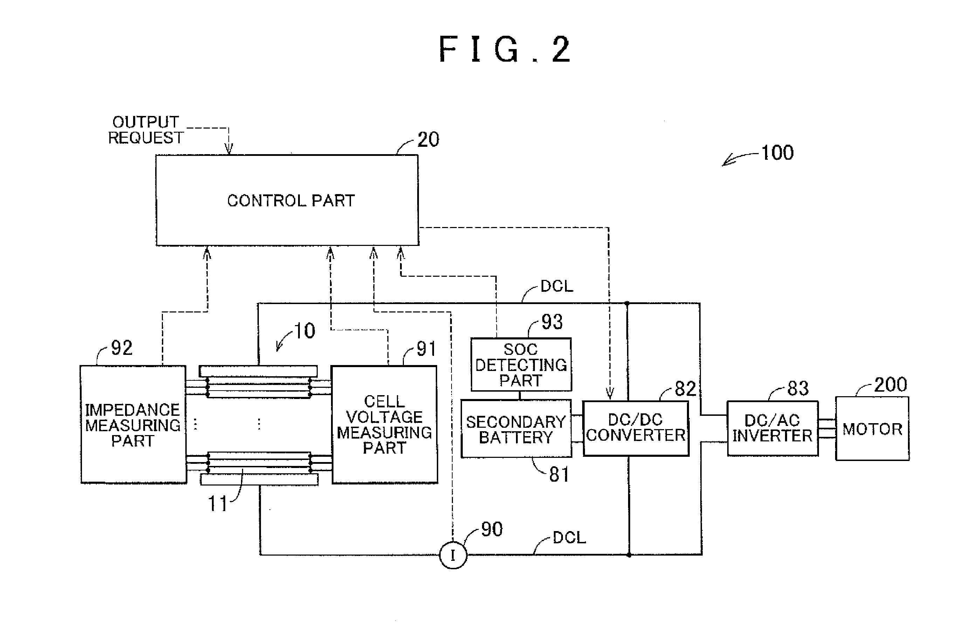

FIG. 2 is a schematic view showing an electrical structure of the fuel cell system 100. In addition to the structure shown in FIG. 1, the fuel cell system 100 is provided with a secondary battery 81, a DC/DC converter 82, a DC/AC inverter 83, a current measuring part 90, a cell voltage measuring part 91, an impedance measuring part 92, and a SOC detecting part 93.

The fuel cell 10 is connected with the DC/AC inverter 83 through direct current wiring DCL, and the DC/AC inverter 83 is connected with a motor 200 that is a drive source of a fuel cell vehicle. The secondary battery 81 is connected with the direct current wiring DCL through the DC/DC converter 82.

The secondary battery 81 is charged by output power of the fuel cell 10 and regenerative electric power of the motor 200, and works as an electric power source together with the fuel cell 10. The secondary battery 81 may be structured by, for example, a lithium ion battery.

The DC/DC converter 82 controls current and voltage of the fuel cell 10 based on a command of the control part 20, and also controls charge and discharge of the secondary battery 81 to variably adjust a voltage level of the direct current wiring DCL. The DC/AC inverter 83 converts direct-current power obtained from the fuel cell 10 and the secondary battery 81 into alternating-current power, and supplies the alternating-current power to the motor 200. In a case where regenerative electric power is generated by the motor 200, the DC/AC inverter 83 converts the regenerative electric power into direct-current electric power.

The current measuring part 90 is connected with the direct current wiring DCL, measures a current value outputted from the fuel cell 10, and outputs the measurement value to the control part 20. The cell voltage measuring part 91 is connected with the single cell 11 of the fuel cell 10, measures voltage of the single cell 11 (herein after, also referred to as "cell voltage"), and outputs the measurement value to the control part 20. The impedance measuring part 92 measures resistance of the single cell 11 (herein after, simply referred to as "cell resistance") by using an alternating current impedance method.

The SOC detecting part 93 is connected with the secondary battery 81. The SOC detecting part 93 detects a SOC (state of charge) of the secondary battery 81, and outputs the detection value to the control part 20. The SOC of the secondary battery 81 means a ratio of a remaining charge (a power storage amount) of the secondary battery 81 with respect to charge capacity of the secondary battery 81. The SOC detecting part 93 detects a SOC of the secondary battery 81 by measuring temperature, electric power, and current of the secondary battery 81. The control part 20 controls charge and discharge of the secondary battery 81 based on the detection value of the SOC detecting part 93 so that the SOC of the secondary battery 81 falls within a predetermined range centered around a reference value (a limit range that is able to suppress deterioration of the secondary battery 81).

A2. Relation between cell voltage and refrigerant temperature:

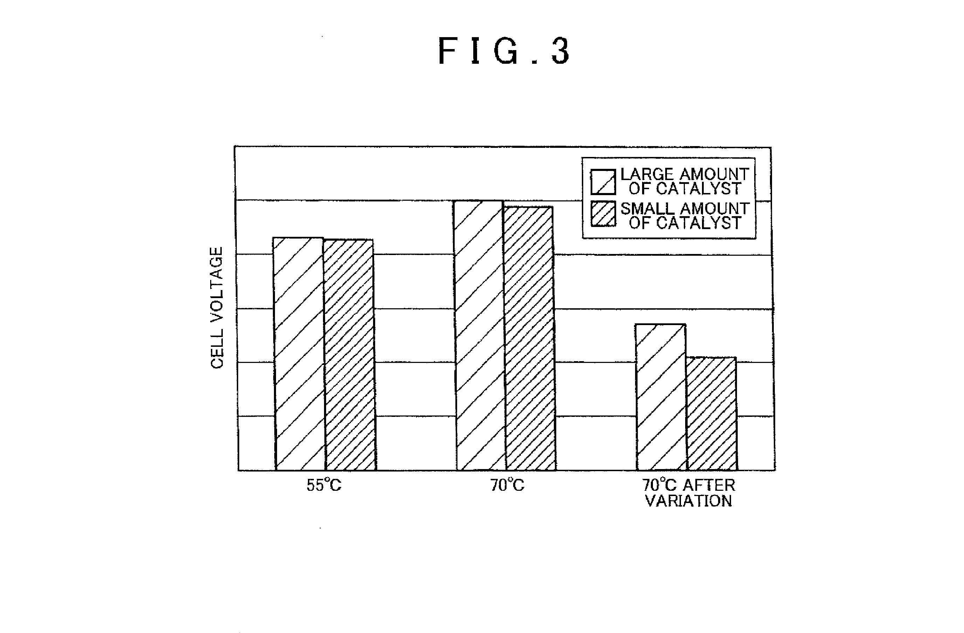

FIG. 3 is a view showing a relation between cell voltage and refrigerant temperature. A vertical axis represents cell voltage. FIG. 3 shows, in the order from left,
   (a) data when refrigerant temperature is 55 °C and before load variation occurs in a fuel cell,
   (b) data when refrigerant temperature is 70 °C and before load variation occurs in a fuel cell, and
   (c) data when refrigerant temperature is 70 °C and after load variation in the fuel cell occurs five times.
In each piece of data, the left side is a result of the first case with a large amount of catalyst, and the right side is a result of a case with a less amount of catalyst than that of the first case. Here, frequency of load variation means the number of times that cell voltage is varied across a predetermined value X. In this embodiment, the predetermined value X is a value that is 80 % of maximum value of the cell voltage (the maximum output voltage)e. Therefore, five-time occurrence of load variation means that cell voltage has changed five times across a value that is 80 % of the maximum output voltage.

The results in FIG. 3 show that cell voltage is higher when the refrigerant temperature is 70 °C compared to the case (i) where refrigerant temperature is 55 °C, and that, in the case (ii) where refrigerant temperature is 70 °C ((a), (b) above), cell voltage is decreased when load variation happens repeatedly. The results in FIG. 3 also show that, compared to a decrease in cell voltage due to a different amount of the catalyst, a decrease in cell voltage due to load variation becomes more conspicuous.

A3. Relation between a position in a cell and current density:

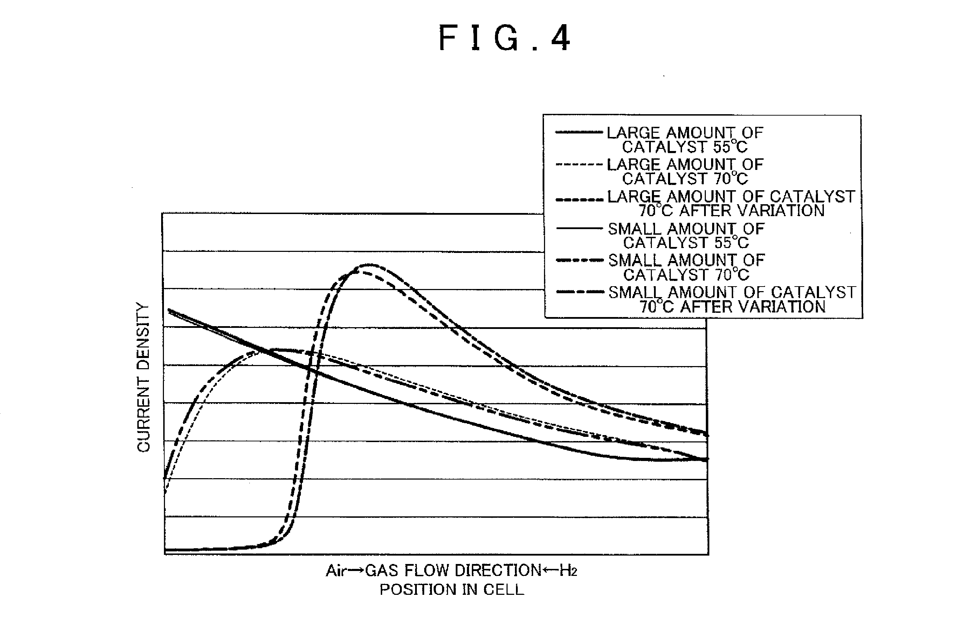

FIG. 4 is a view showing a relation between a position in a cell and current density. A vertical axis represents current density. A horizontal axis represents a position in a cell. In the horizontal axis, a left side of the drawing shows an inlet side of cathode gas, and a right side of the drawing shows an outlet side of cathode gas.

Test examples shown in FIG. 4 are the same as the test examples shown in FIG. 3. This means that FIG. 4 shows
(a) data when refrigerant temperature is 55 °C and before load variation occurs in a fuel cell,
(b) data when refrigerant temperature is 70 °C and before load variation occurs in a fuel cell, and
(c) data when refrigerant temperature is 70 °C and after load variation in a fuel cell occurs five times.
Here, frequency of load variation means the number of times that cell voltage is varied across a predetermined value X. The predetermined value X is a value that is 80 % of maximum value of the cell voltage (the maximum output voltage).

The results in FIG. 4 show the following. In the case where refrigerant temperature is 55 °C, current density is high on the inlet side of the cathode gas regardless of an amount of catalyst before load to the fuel cell is varied, and current density is decreased towards the outlet side of the cathode gas. In the case where refrigerant temperature is 70 °C ((b), (c) above), current density is low on the inlet side of the cathode gas, becomes the highest at a point between the inlet side and the outlet side of the cathode gas, and is decreased towards the outlet side of the cathode gas. In the case where refrigerant temperature is 70 °C, a peak of current density is moved toward an inner part of the cell when an amount of catalyst is small, compared to a case of a large amount of catalyst. Current density on the inlet side of the cathode gas is reduced due to load variation.

According to the results, it is estimated that (i) the higher refrigerant temperature becomes, the drier the inlet side of the cathode gas becomes, thereby causing a decrease in current density, and that (ii) load variation causes a drying state of the inlet side of the cathode gas. Therefore, it is understood that assuming whether or not the inlet side of the cathode gas is in a drying state is important in terms of improvement of power generation efficiency of a fuel cell.

A4. Control of the fuel cell system:

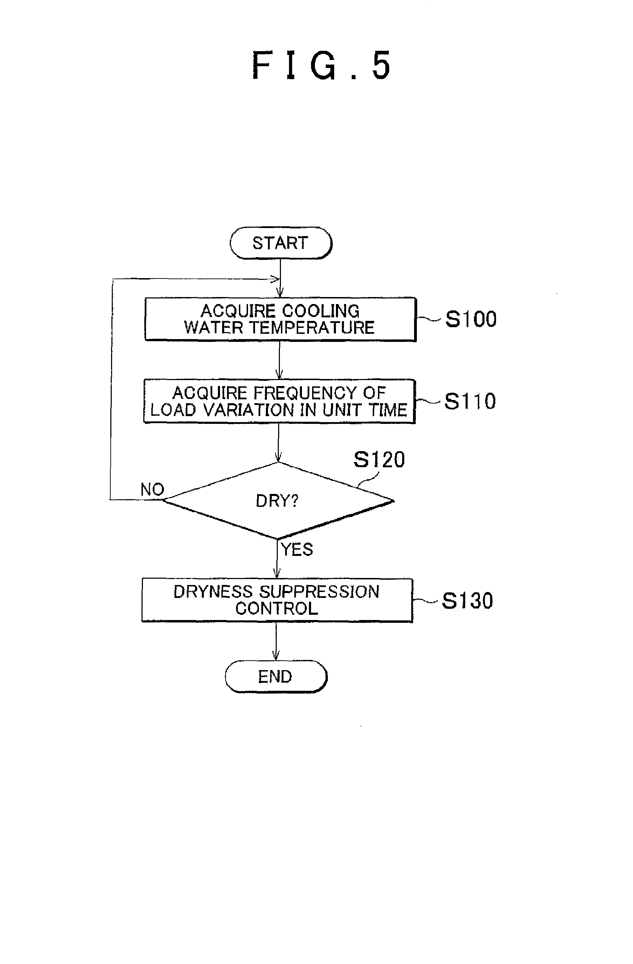

FIG. 5 is an explanatory view showing a control processing flow of the fuel cell system 100 according to the first embodiment. The control processing of the fuel cell system 100 is started when there is a command for starting operation of the fuel cell system 100 (for example, when an ignition switch (not shown) is turned on).

In step S100, the control part 20 acquires temperature of cooling water. To be specific, the control part 20 causes the downstream side temperature sensor 76b to measure temperature of a medium for cooling the fuel cell 10, and acquires the measurement value. The "downstream side temperature sensor 76b" according to this embodiment can be regarded as a "sensor" of the invention.

Next, in step S110, the control part 20 acquires frequency of load variation of the fuel cell 10 per unit time. To be specific, the control part 20 causes the current measuring part 90 to measure current, and acquires the number of times that current is varied across a predetermined value X. In this embodiment, the unit time is set to 10 seconds, and the predetermined value X is set to 80 % of maximum output current of the fuel cell. An operation part of the control part 20, which carries out the processing of step S110, is shown as an acquisition part 21 in FIG. 1.

Thereafter, in step S120, the control part 20 estimates whether or not the fuel cell 10 is in a drying state based on information including the temperature acquired in step S100, and the frequency of load variation acquired in step S110. In short, the control part 20 estimates that inside of the fuel cell 10 is not in a drying state when the frequency of load variation per unit time is under specified frequency. On the other hand, the control part 20 estimates that inside of the fuel cell 10 is in a drying state when the frequency of load variation per unit time satisfies the specified frequency. According to the fuel cell system 100 in this form, it is possible to estimate whether or not the fuel cell is in a drying state by using equipment that is usually provided in the fuel cell system. An operation part of the control part 20, which carries out the processing of the step S120, is shown as an estimation part 22 in FIG. 1.

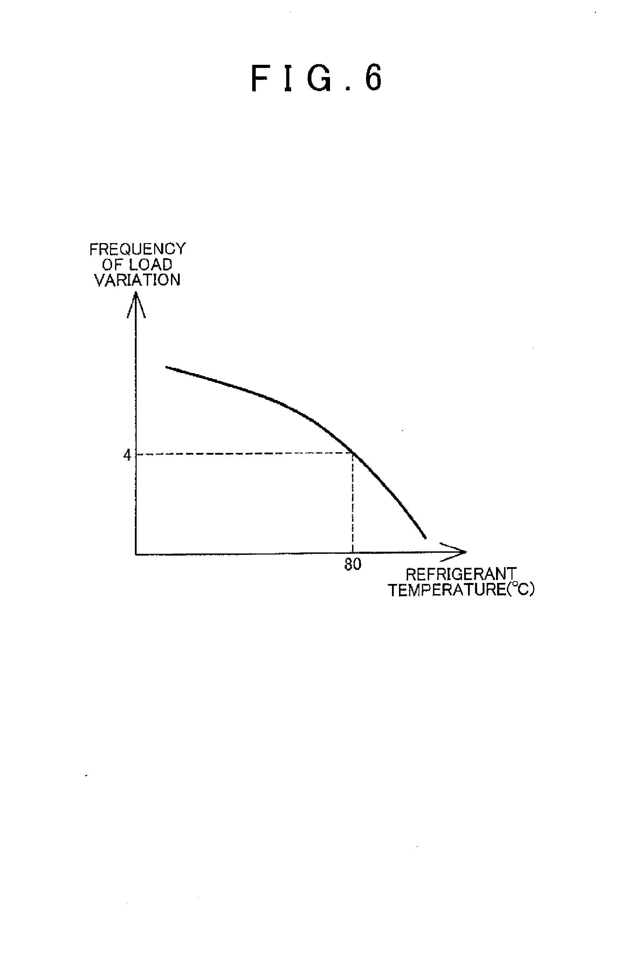

FIG. 6 is a view showing a relation between frequency of load variation and refrigerant temperature. A horizontal axis represents refrigerant temperature, and a vertical axis represents frequency of load variation. FIG. 6 shows that, in the case where refrigerant temperature is 80 °C, it is estimated that the fuel cell 10 is in a drying state once frequency of load variation becomes four times. In this embodiment, the control part 20 determines specified frequency for load variation, with which it is estimated that inside of the fuel cell 10 is in a drying state, based on refrigerant temperature. Also, in FIG. 6, a lower side of a curve shown by frequency of load variation and refrigerant temperature can be regarded as a wet area of the fuel cell, and an upper side of the curve can be regarded as a dry area of the fuel cell. It can be said that FIG. 6 is a map that shows the wet area and the dry area. In this embodiment, it is determined whether or not the fuel cell 10 is in a drying state by using such a map.

The higher refrigerant temperature becomes, the more likely it is that inside of the fuel cell 10 becomes a drying state. Further, the higher the frequency of load variation becomes, the more likely it is that inside of the fuel cell 10 becomes a drying state. Therefore, the higher refrigerant temperature becomes, the more likely it is that inside of the fuel cell 10 is estimated to be in a drying state even in a case where frequency of load variation is low.

In step S120 (see FIG. 5), when the control part 20 estimates that fuel cell 10 is not in a drying state, the processing returns to step S100.

On the other hand, in step S120, when the control part 20 estimates that the fuel cell 10 is in a drying state, processing for improving a drying state (also referred to as a "dryness suppression control") is carried out in step S130. To be specific, the control part 20 controls the refrigerant circulation pump 75 to increase a flow rate of cooling water compared to the case where the fuel cell 10 is not in a drying state. An operation part of the control part 20, which carries out the processing of step S130, is shown as an improvement part 23 in FIG. 1.

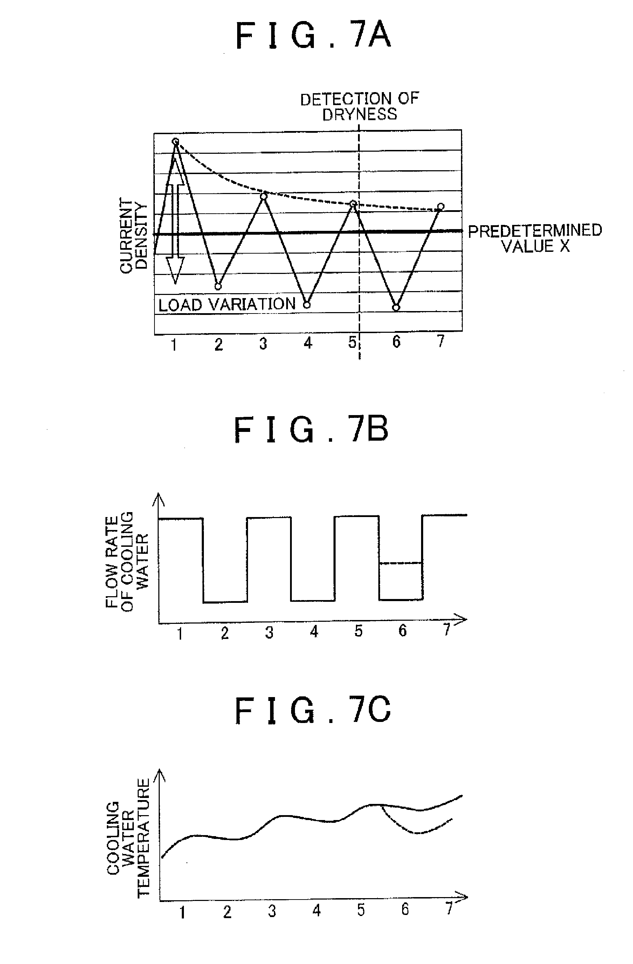

FIG. 7A to FIG. 7C are views for explaining detection of a drying state and the dryness suppression control. Horizontal axes of FIG. 7A to FIG. 7C show frequency of load variation. A vertical axis in FIG. 7A represents current density, a vertical axis in FIG. 7B represents a flow rate of cooling water, and a vertical axis in FIG. 7C represents temperature of cooling water.

In this embodiment, a flow rate of cooling water is in correlation with current density. In other words, when current density is high in a certain state, a flow rate of cooling water is controlled to increase. On the other hand, when current density is low in a certain state, a flow rate of cooling water is controlled to decrease (see FIG. 7A, FIG. 7B). With this control, temperature of cooling water remains nearly constant (see FIG. 7C).

In this embodiment, when the frequency of variation is five times, the control part 20 starts the dryness suppression control. As shown in FIG. 7A, when the variation frequency reaches five times, the control part 20 detects dryness of the fuel cell 10.

The control part 20 that has detected dryness of the fuel cell 10 performs control so that a flow rate of cooling water becomes higher compared to that in a case where it is estimated that the fuel cell 10 is not in a drying state. To be specific, a usual flow rate of cooling water is controlled as shown by a solid line. However, at the time of the dryness suppression control, a flow rate of cooling water is controlled as shown by a broken line (see FIG. 7B).

As a result, although the behavior shown by the solid line is observed with a normal temperature of cooling water, a temperature of cooling water behaves like the broken like at the time of the dryness suppression control (see FIG. 7C). By doing -so, temperature inside the fuel cell 10 is decreased, thereby suppressing a drying state inside the fuel cell 10, especially a drying state of the inlet side of the cathode gas. According to the fuel cell system in this form, it is possible to improve a drying state of a fuel cell by using equipment that is usually provided in the fuel cell system.

B. Second embodiment:
This embodiment is the same as the first embodiment apart from a dryness suppression control method. In short, in the first embodiment, the refrigerant circulation pump 75 is controlled as the dryness suppression control. However, in the second embodiment, the hydrogen circulation pump 64 is controlled as a substitution for the above control.

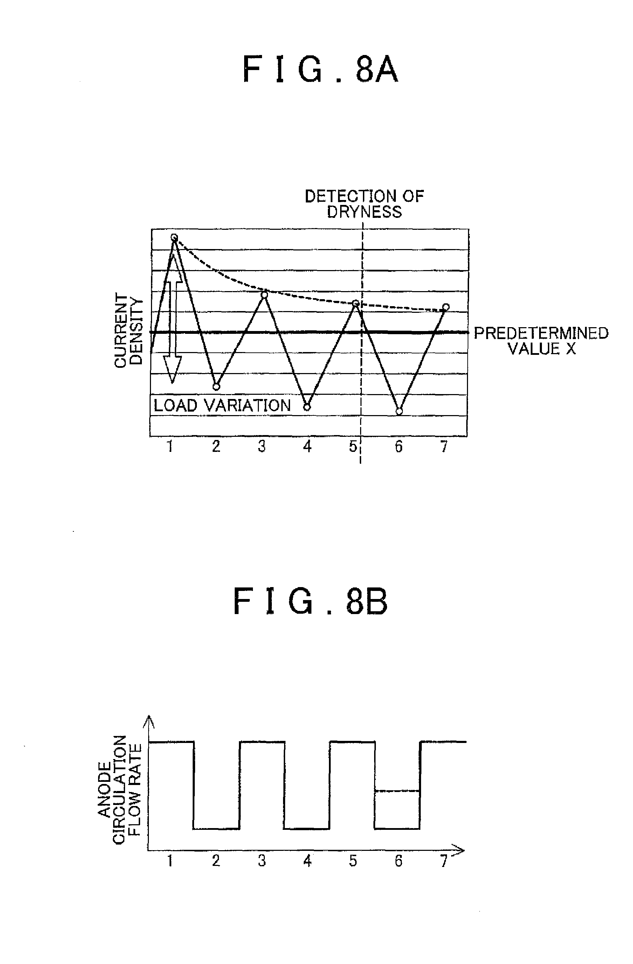

FIG. 8A and FIG. 8B are views for explaining detection of a drying state and dryness suppression control. Horizontal axes of FIG. 8A and FIG. 8B show frequency of load variation. A vertical axis of FIG. 8A represents current density, and a vertical axis of FIG. 8B represents a circulation flow rate of the anode gas.

In this embodiment, a circulation flow rate of the anode gas is in correlation with current density. In short, when current density is high in a certain state, a circulation flow of the anode gas is controlled to increase. On the other hand, when current density is small in a certain state, a circulation flow of the anode gas is controlled to decrease (see FIG. 8A, FIG. 8B).

Similar to the first embodiment, in this embodiment, when the frequency of variation is five times, the control part 20 starts the dryness suppression control. As shown in FIG. 8A, when the frequency of variation reaches five times, the control part 20 detects dryness.

The control part 20 that has detected dryness of the fuel cell 10 performs control so that a circulation flow rate of the anode gas becomes larger than that in the case where it is estimated that the fuel cell 10 is not in a drying state. To be specific, a usual circulation flow rate of the anode gas is controlled as shown by a solid line. However, at the time of the dryness suppression control, a circulation flow rate of the anode gas is controlled as shown by a broken line (see FIG. 8B).

In this embodiment, a counter flow type is employed for the fuel cell 10. Also, since a circulation flow rate of the anode gas becomes large, water is supplied to the outlet side of the anode gas, in other words, the inlet side of the cathode gas. As a result, it is possible to suppress a drying state of the fuel cell 10, especially a drying state on the inlet side of the cathode gas. According to this fuel cell system, it is possible to improve a drying state of a fuel cell by using equipment that is usually provided in the fuel cell system.

C. Modified examples:
C1. Modified example 1:
   In this embodiment, a so-called counter flow type is employed for the fuel cell 10. However, the invention is not limited to this, and a so-called co-flow type and a so-called cross-flow type may also be employed.

### C2. Modified example 2:

In this embodiment, the control part 20 acquires frequency of load variation in which current is changed across the predetermined value X. However, the invention is not limited to this. When the control part 20 acquires frequency of load variation, a dead zone may be provided. For example, with a dead zone that is set to a range from 75 % to 85 % of the maximum output current, frequency may be counted when a current value is under 75 % of the maximum output current and over 85 % of the maximum output current. By doing so, counting caused by minute changes of current is reduced, thus making it possible to assume more accurately whether or not the fuel cell 10 is in a drying state. In the foregoing embodiment, the predetermined value X is set to 80 % of the maximum output current of the fuel cell. However, the predetermined value X may be any value within a range from 75 % to 85 % of the maximum output current. Further, the predetermined value X may be 80 % of maximum output voltage of the fuel cell.

When the control part 20 acquires frequency of load variation, the control part 20 may acquire frequency of load variation at intervals of a predetermined period (for example, one second). By doing so, counting caused by minute changes of current is reduced, thus making it possible to assume more accurately whether or not the fuel cell 10 is in a drying state.

### C3. Modified example 3:

In this embodiment, the control part 20 acquires frequency of load variation based on a current value. However, the invention is not limited to this. The cell voltage , a current, and an accelerator opening are parameters correlated each other. The control part 20 may acquire frequency of load variation based on an output request from outside (for example, accelerator opening) or the cell voltage. When the frequency of load variation are obtained using the accelerator opening, the predetermined value X is preferably a value within 75% to 85% of the maximum accelerator opening. When the frequency of load variation are obtained using the cell voltage, the predetermined value X is preferably a value within 75% to 85% of the maximum value of the cell voltage (the maximum output voltage).

### C4. Modified example 4:

In the first embodiment, control is performed to increase a flow rate of cooling water when the flow rate of cooling water is small, as the dryness suppression control. However, the present invention is not limited to this. The control part 20 may perform control to increase a flow rate of cooling water even more when the flow rate of cooling water is large. By doing so, it is possible to perform dryness suppression control more swiftly.

### C5. Modified example 5:

In this embodiment, a drying state of the fuel cell is estimated by using temperature measured by the "downstream side temperature sensor 76b". However, the invention is not limited to this. A drying state of the fuel cell may be estimated by using temperature measured by the "upstream side temperature sensor 76a".

### C6. Modified example 6:

In this embodiment, in the case where the control part 20 estimates that the fuel cell 10 is in a drying state, the control part 20 performs control to improve the drying state. However, the invention is not limited to this. When the control part 20 estimates that the fuel cell 10 is in a drying state, the control part 20 may draw a user's attention by sound, light, or vibration that indicates that the fuel cell 10 is in a drying state. By doing so, a user is able to recognize a drying state of the fuel cell 10.

### C7. Modified example 7:

In this embodiment, the estimation part estimates whether or not the fuel cell is in a drying state regardless of refrigerant temperature. However, the invention is not limited to this. In short, the estimation part may not estimate whether or not the fuel cell is in a drying state when refrigerant temperature is lower than a threshold value T, and may estimate whether or not the fuel cell is in a drying state when the temperature is equal to or higher than the threshold value T. An example of the threshold value T is a temperature within 40 to 50 °C, e.g., 45 °C. By doing so, the estimation part does not make estimation when the temperature is lower than the threshold value. Therefore, according to the fuel cell system in this form, processing is simplified.

### C8. Modified example 8:

In the second embodiment, a drying state of the fuel cell is improved by increasing a circulation flow rate of the anode gas, but an amount of the anode gas supplied from the hydrogen tank 52 may be increased. By increasing the supply amount of the anode gas, it is possible to transport a larger amount of produced water to the downstream side of the anode gas, and increase an amount of produced water itself.

The invention is not limited to the foregoing embodiments and modified examples, and is realized in various structures without departing from the gist of the invention. For example, the technical features described in the embodiments and the modified examples, which correspond to the technical features in each of the forms described in Summary of Invention, may be substituted or combined as appropriate in order to solve a part of or all of the problems stated earlier, or to achieve a part or all of the foregoing effects. Also, the technical features, which are not explained as essential in this specification, may be deleted as appropriate.

## Claims

1. A fuel cell system comprising:
a sensor (76a, 76b) that measures temperature of a medium that cools a fuel cell;
an acquisition part (21) configured to acquire frequency of load variation of the fuel cell per unit time; and
an estimation part (22) configured to estimate whether or not the fuel cell is in a drying state based on information including the measured temperature and the acquired frequency of load variation.

2. The fuel cell system according to claim 1, further comprising:
an improvement part (23) configured to improve the drying state when it is estimated that the fuel cell is in the drying state.

3. The fuel cell system according to claim 2, wherein,
when the estimation part (22) estimates that the fuel cell is in the drying state, the improvement part (23) increases an amount of the medium supplied to the fuel cell to be larger than that in a case where it is estimated that the fuel cell is not in the drying state.

4. The fuel cell system according to claim 2 or 3, wherein
the fuel cell (10) includes an anode gas passage, a cathode gas passage, and a plurality of cells that includes a membrane electrode assembly sandwiched between the anode gas passage and the cathode gas passage,
anode gas and cathode gas flow against each other within a cell surface of the fuel cell, and an outlet of the anode gas passage is on an inlet side of the cathode gas passage through the membrane electrode assembly, and
when the estimation part (22) estimates that the fuel cell is in the drying state, the improvement part (23) increases an amount of the anode gas supplied to the fuel cell to be larger than that in a case where it is estimated that the fuel cell is not in the drying state.

5. The fuel cell system according to any one of claims 1 to 4, wherein
the estimation part (22) does not estimate whether or not the fuel cell is in the drying state in a case where the measured temperature is lower than a threshold value, and the estimation part (22) estimates whether or not the fuel cell is in the drying state in a case where the measured temperature is equal to or higher than the threshold value.

6. The fuel cell system according to any one of claims 1 to 5, wherein
the acquisition part (21) counts the number of times that a current value of the fuel cell exceeds a predetermined value from a value equal to or smaller than the predetermined value, and the number of times that the current value becomes equal to or smaller than the predetermined value from a value exceeding the predetermined value, as the frequency of load variation, and
the predetermined value is a value within a range from 75 % to 85 % of a maximum output current of the fuel cell.

7. The fuel cell system according to any one of claims 1 to 5, wherein
the acquisition part (21) counts the number of times that a current value of the fuel cell exceeds an upper limit value of a dead zone from a value smaller than a lower limit value of the dead zone, and the number of times that the current value becomes lower than the lower limit value of the dead zone from a value exceeding the upper limit value of the dead zone, as the frequency of load variation.

8. An estimation method of drying state of a fuel cell comprising:
measuring temperature of a medium for cooling the fuel cell (S100);
acquiring frequency of load variation of the fuel cell per unit time (S110); and
estimating a drying state of the fuel cell based on information including the measured temperature and the acquired frequency of load variation (S120).

9. A fuel cell system control method comprising:
carrying out the method described in claim 8; and
improving the drying state when it is estimated that the fuel cell is in the drying state (S130).

10. The control method according to claim 9, wherein,
when it is estimated that the fuel cell is in the drying state, an amount of the medium supplied to the fuel cell is increased to be larger than that of a case where it is estimated that the fuel cell is not in the drying state.

11. The control method according to claim 9, wherein
the fuel cell includes an anode gas passage, a cathode gas passage, and a plurality of cells that includes a membrane electrode assembly sandwiched between the anode gas passage and the cathode gas passage,
anode gas and cathode gas flow against each other within a cell surface of the fuel cell, and an outlet of the anode gas passage is on an inlet side of the cathode gas passage through the membrane electrode assembly, and,
when it is estimated that the fuel cell is in the drying state, an amount of the anode gas supplied to the fuel cell is increased to be larger than that in a case where it is estimated that the fuel cell is not in the drying state.
